# EUROPEAN PATENT APPLICATION

(11) **EP 1 978 404 A1**
(43) Date of publication of application: **08.10.2008**
(21) Application number: 08153949.6
(22) Date of filing: 02.04.2008
(51) Int. Cl.: G03F 1/14

(54) **Pellicle**

(30) Priority: 04.04.2007 JP 2007098616
(71) Applicant: Shin-Etsu Chemical Co., Ltd., Tokyo (JP)
(72) Inventor: Shirasaki, Toru, Annaka-shi Gunma (JP)
(74) Representative: Müller, Thomas

(57) **Abstract**

The invention aims at providing a pellicle that does not impair photomask flatness when the pellicle is bonded to the photomask. In the pellicle of the present invention, the surface at which the pellicle frame is mounted on a photomask has a flatness not exceeding 30 µm, while the surface of the pellicle frame on the pellicle membrane side has a flatness not exceeding 15 µm.

## Description

### BACKGROUND OF THE INVENTION

### 1. Field of the Invention

The present invention relates to a lithographic pellicle, in particular to a lithographic pellicle used as dust-proof protection in the manufacture of semiconductor devices such as LSI or ultra-LSI. More particularly, the invention relates to a lithographic pellicle used for ultraviolet exposure light of 200 nm or shorter wavelength used for patterning light exposure which requires high resolution.

### 2. Description of the Related Art

Conventionally, the manufacture of semiconductor devices such as LSI and ultra-LSI, or liquid crystal display panels and the like, has involved employing procedures such as lithography for the patterning of semiconductor wafers or liquid crystal original plates through irradiation of light. In lithography, a photomask is used as an original plate for patterning, such that the pattern on the photomask is replicated to a wafer or a liquid crystal substrate.

However, there is a problem that any dust adhering to the employed original plate absorbs and reflects light, which deforms and roughens the edges of the replicated patterning, thereby detracting from dimensions, quality, and appearance, and impairing the performance of the semiconductor device and/or liquid crystal display panel, while reducing the manufacturing yield thereof.

Thus, these operations are ordinarily carried out in clean rooms, but keeping exposure original plates clean at all times in such clean rooms is difficult, and hence pellicles having good light transmissivity are adhered, as dust-proof protection, to the surface of exposure original plates.

The advantage of the pellicle is that dust does not attach directly to the surface of the exposure original plate, but becomes adhered to the pellicle membrane, so that if focus is in accord with the pattern of the exposure original plate during lithography, transfer is not affected by dust on the pellicle.

The pellicle is made up of a pellicle frame comprising aluminum, stainless steel, polyethylene or the like, a transparent pellicle membrane adhered on the upper surface of the pellicle frame, comprising nitrocellulose, cellulose acetate or the like having good light transmissivity, an adhesive layer coated on the lower surface of the pellicle frame, and a release layer (separator) adhered on the adhesive layer. The adhesive bonding between the pellicle frame and pellicle membrane is carried out by coating a good solvent for the pellicle membrane material and then air-drying the solvent (Japanese Patent Application Laid-open No. S58-219023) or using an adhesive agent such as an acrylic resin, epoxy resin or the like (US Patent No. 4861402, Japanese Patent Examined Application Publication No. S63-27707, Japanese Unexamined Patent Application Laid-open No. H07-168345).

As a result of ever higher lithography resolutions encountered in recent years, the employed light sources are gradually shifting to shorter wavelengths in order to realize such resolutions. Specifically, there has been a shift towards g-line (436 nm), i-line (365 nm), KrF excimer lasers (248 nm) in ultraviolet light, while ArF excimer lasers (193 nm) have begun to be used recently.

In a semiconductor exposure device, the pattern drawn on a photomask is burned onto a silicon wafer by way of short-wavelength light. Irregularities on the photomask and the silicon wafer give rise however to focal shift, which impairs the pattern printed onto the wafer. The required flatness from photomasks and silicon wafers is getting more stringent as the patterning becomes finer and finer.

For instance, the required flatness from photomasks is becoming gradually more demanding, from a flatness of 2 µm at the pattern plane, down to 0.5 µm and 0.25 µm for the 65 nm node and beyond.

Pellicles are affixed onto finished photomasks as dust-proof protection of the latter. However, the flatness of a photomask may change upon affixing of a pellicle on the photomask. Deficient photomask flatness can give rise to problems such as the above-described focal shift. Changes in flatness alter the shape of the pattern drawn on the photomask and give rise also to problems as regards focal displacement on the photomask.

In contrast, photomask flatness may be improved by pellicle affixing. Although in this case focal shift is not a problem, pattern shape changes still give rise to problems as regards focal displacement on the photomask.

In leading-art photomasks, thus, photomask flatness must not change when a pellicle is affixed. However, photomask flatness often changes when a pellicle is affixed thereto.

In light of the above, it is an object of the present invention to provide a pellicle that does not impair photomask flatness when a pellicle is bonded to a photomask.

### BRIEF SUMMARY OF THE INVENTION

In the pellicle of the present invention, the surface at which the pellicle frame is mounted on a photomask has a flatness not exceeding 30 µm, while the surface of the pellicle frame on the pellicle membrane side has a flatness not exceeding 15 µm. The present invention provides a photolithographic pellicle which comprises a frame made of a rigid material having two opposite end surfaces of which the first end surface at which the pellicle is mounted on a photomask has a flatness not exceeding 30µm and the second end surface opposite to the first end surface has a flatness not exceeding 15µm.

In the pellicle of the present invention, strain is unlikely to occur in either the pellicle or the photomask, even with the pellicle affixed to the photomask. The invention enables thus high-performance lithography.

There are several factors that give rise to photomask flatness changes upon affixing of a pellicle, but the most relevant, as is uncovered by the inventor, is the flatness of the pellicle frame.

Pellicle frames are usually made of aluminum. Pellicle frames, the interior of which is hollowed out, have a width of about 150 mm, a length of about 110 to 130 mm and a thickness of about 2 mm. To manufacture the frame, a pellicle frame shape is usually cut out of an aluminum plate, or an aluminum material made into a frame shape through extrusion molding.

The flatness of the pellicle frame ranges ordinarily from about 20 to 80 µm. When a pellicle using a frame having such substantial flatness is affixed onto a photomask, however, the shape of the frame becomes transferred to the photomask, deforming the latter.

During affixing onto the photomask, the pellicle is pressed against the photomask with a substantial force, of 2.0 to 3.9 MPa (20 to 40 kgf). Herein, a photomask surface having a flatness no greater than several µm is flatter than the frame, and the rigidity of the framework is also high, and hence the frame is assumed to undergo elastic deformation to a flat state when pressed against the photomask.

The frame tends to revert back to its original shape when pressing is over, but since it is bonded to the photomask surface, the photomask deforms as well consequently.

The pellicle is affixed to the photomask through an adhesive applied onto the pellicle. Such an adhesive is softer than the photomask and the frame, and can thus absorb stress. The thickness of the adhesive, however, is small, ordinarily no greater than 0.4 mm, and hence the adhesive fails to cause a sufficient stress absorption effect. Photomask deformation occurs therefore when the frame shape is not flat.

Upon affixing to the photomask, forces act on the side of the pellicle frame to which the pellicle membrane is attached. If the flatness of the frame on the side to which the pellicle membrane is attached is poor, bulging portions are acted upon locally by large forces, thereby causing greater deformation of the frame in the corresponding portions. If flatness is sufficiently good on the side of pellicle membrane attachment, the above-described forces fail to act locally, and frame deformation due to pellicle mounting is suppressed. Photomask deformation is thus curbed as a result.

When frame flatness on the side of pellicle membrane attachment is sufficiently good, frame deformation due to pellicle mounting is suppressed, and hence the photomask does not deform that much, even assuming flatness to be poor on the side affixed to the photomask.

The photomask adhesive layer formed on the side of the frame that is affixed to the photomask is sandwiched between the pellicle frame and the photomask. If the flatness of the frame on the side affixed to the photomask is poor, the photomask adhesive is subjected to locally substantial compression, which results in photomask deformation. The adhesive layer, however, is relatively soft compared with the frame and the photomask, and thus the influence of flatness of the frame on the side affixed to the photomask is smaller than the influence of flatness on the side of the pellicle membrane.

In terms of pellicle frame flatness, a pellicle frame having uniform thickness results in flatness being identical on the side at which the pellicle frame is mounted onto the photomask and on the side at which the pellicle membrane is attached. Normally, however, frames have non-uniform thickness, and thus flatness on the side of photomask mounting is different from the flatness on the side of pellicle membrane attachment.

As explained above, although improving pellicle frame flatness is important for suppressing photomask deformation, the flatness on the side of pellicle membrane attachment exerts the greater influence on photomask deformation. Photomask deformation can therefore be curbed effectively by improving the flatness that portion in particular.

### DETAILED DESCRIPTION OF THE INVENTION

In order to overcome the above drawbacks, the inventor found that photomask deformation could be kept small by keeping at or below 30 µm of the flatness of the surface at which the pellicle frame is mounted on a photomask, and by keeping at or below 15 µm of the flatness of the surface of the pellicle frame on the pellicle membrane side.
The pellicle frame is an integral framework made of a rigid material such as aluminum, an aluminum alloy, surface anodized aluminum and stainless steel.

When the flatness of the pellicle frame is poor, as described above, the shape of the pellicle frame is transferred to the photomask shape when the pellicle is affixed to the photomask. When, for instance, one side of the pellicle frame is concave, as viewed from the side at which the adhesive is applied, the photomask deforms into a convex shape along that side of the pellicle, upon affixing of the latter onto the photomask. Conversely, when one side of the pellicle frame is convex, the photomask deforms into a concave shape along that side of the pellicle, upon affixing of the latter onto the photomask.

Changes in photomask flatness depend both on the absolute value of the flatness of the pellicle frame, and also on the relationship between frame shape and photomask shape. That is, for a given frame flatness value, different frame shapes may result in different changes in photomask flatness when the frame is affixed to the same photomask. Conversely, affixing frames of identical shape to different photomasks may result in different changes in photomask flatness.

Such shape dependency lessens when the frame is sufficiently flat. Hence, improving frame flatness as much as possible allows reducing photomask deformation upon affixing of the pellicle onto the photomask.

To work out the flatness of a pellicle frame, the frame is normally placed on a smooth surface, the heights of the frame end surfaces are measured, and then a virtual plane is calculated based on the various point values. Flatness is then taken as the difference between the largest and smallest deviation from the virtual plate of the various points.

To measure frame flatness, any height of points may be measured on a frame, although ordinarily measuring a total eight points including four points on the four corners and four points on the centers of respective straight lines is sufficient for calculating the flatness of the frame as a whole.

As described above, the flatness of the photomask is far superior to that of the frame. Although improving frame flatness along with that of the photomask does reduce deformation caused by pellicle affixing, in practice it would be both extremely difficult and uneconomical to finish the flatness of an aluminum frame to match the flatness of a photomask on a quartz substrate.

The results of studies on frame flatness indicate that during affixing of a pellicle manufactured using a frame onto the photomask, deformation of the photomask can be kept at or below 0.1 µm, which is a satisfactory result, by keeping at or below 30 µm the flatness of the surface at which the pellicle frame is mounted on the photomask, and by keeping at or below 15 µm of the flatness of the surface of the pellicle frame on the pellicle membrane side.

Photomask flatness changes become smaller as frame flatness improves. Keeping frame flatness, for instance, at or below 10 µm or at or below 5 µm allows curbing photomask flatness changes even better should it be necessary to further minimize photomask flatness changes, thus affording a high-quality pellicle-bearing photomask.

### EXAMPLES

Examples of the present invention are explained below, although the invention is in no way meant to be limited to or by these examples.

### Example 1

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A frame made of aluminum having undergone a surface anodizing treatment (outer dimensions: 149 mm × 122 mm × 5.8 mm) exhibited, upon measurement, a flatness of 30 µm on the photomask-affixing side, and of 15 µm on the pellicle membrane side. A photomask adhesive was applied onto the end face of the frame, on the photomask affixing side, while a membrane adhesive was applied onto the other end side of the frame. Thereafter, the pellicle membrane was affixed to the membrane adhesive side of the aluminum framework, and the membrane on the outer periphery of the frame was cut out to finish thereby a pellicle.

The finished pellicle was affixed, under a load of 20 kg, onto a photomask having a length-width average of 142 mm and a flatness of 0.25 µm. The flatness of the pellicle-bearing photomask was then measured again, to yield 0.33 µm. Although worse by 0.08 µm, flatness was successfully kept within a satisfactory range.

### Example 2

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A frame made of aluminum having undergone a surface anodizing treatment (outer dimensions: 149 mm × 122 mm × 5.8 mm) exhibited, upon measurement, a flatness of 12 µm on the photomask-affixing side, and of 6 µm on the pellicle membrane side. A photomask adhesive was applied onto the end face of the frame, on the photomask affixing side, while a membrane adhesive was applied onto the other end side of the frame. Thereafter, the pellicle membrane was affixed to the membrane adhesive side of the aluminum framework, and the membrane on the outer periphery of the frame was cut out to finish thereby a pellicle.

The finished pellicle was affixed, under a load of 20 kg, onto a photomask having a length-width average of 142 mm and a flatness of 0.25 µm. The flatness of the pellicle-bearing photomask was then measured again, to yield 0.24 µm. The change in photomask flatness was extremely small, of 0.01 µm, in what was a very satisfactory result. The shape of the photomask exhibited virtually no change.

### Example 3

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A frame made of aluminum having undergone a surface anodizing treatment (outer dimensions: 149 mm × 122 mm × 5.8 mm) exhibited, upon measurement, a flatness of 6 µm on the photomask-affixing side, and of 12 µm on the pellicle membrane side. A photomask adhesive was applied onto the end face of the frame, on the photomask affixing side, while a membrane adhesive was applied onto the other end side of the frame. Thereafter, the pellicle membrane was affixed to the membrane adhesive side of the aluminum framework, and the membrane on the outer periphery of the frame was cut out to finish thereby a pellicle.

The finished pellicle was affixed, under a load of 20 kg, onto a photomask having a length-width average of 142 mm and a flatness of 0.25 µm. The flatness of the pellicle-bearing photomask was then measured again, to yield 0.21 µm. The change in photomask flatness was a satisfactory 0.04 µm. The result was better than that of Example 1, but worse than that of Example 2. The shape of the photomask exhibited no substantial change.

### Comparative Example 1

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A frame made of aluminum having undergone a surface anodizing treatment (outer dimensions: 149 mm × 122 mm × 5.8 mm) exhibited, upon measurement, a flatness of 58 µm on the photomask-affixing side, and of 52 µm on the pellicle membrane side. A photomask adhesive was applied onto the end face of the frame, on the photomask affixing side, while a membrane adhesive was applied onto the other end side of the frame. Thereafter, the pellicle membrane was affixed to the membrane adhesive side of the aluminum framework, and the membrane on the outer periphery of the frame was cut out to finish thereby a pellicle.

The finished pellicle was affixed, under a load of 20 kg, onto a photomask having a length-width average of 142 mm and a flatness of 0.25 µm. The flatness of the pellicle-bearing photomask was then measured again, to yield 0.48 µm. Photomask flatness worsened thus considerably. The pellicle frame exhibited a convex shape on the middle of the long side thereof, as viewed from the pellicle membrane. After affixing of the pellicle on the photomask, the shape of the photomask showed a convex shape along the direction of the pellicle long side, caused by transfer of the frame shape.

**Table 1 - Flatness measurement results**

| | Frame flatness(µm) | | Photomask flatness(µm) | | |
|---|---|---|---|---|---|
| | Photomask side | Pellicle membrane side | Before pellicle affixing | After pellicle affixing | Deformation |
| Example 1 | 30 | 15 | 0.25 | 0.33 | + 0.08 |
| Example 2 | 12 | 6 | 0.25 | 0.24 | - 0.01 |
| Example 3 | 6 | 12 | 0.25 | 0.21 | - 0.04 |
| Comparative Example 1 | 58 | 52 | 0.25 | 0.48 | + 0.23 |

In the present invention, thus, strain is unlikely to occur in either the pellicle or the photomask, even with the pellicle affixed to the photomask. The invention allows therefore carrying out high-performance lithography, making thus a major contribution to industrial fields where semiconductor lithography is involved.

## Claims

1. A photolithographic pellicle which comprises a frame made of a rigid material having two opposite end surfaces of which the first end surface at which the pellicle is mounted on a photomask has a flatness not exceeding 30µm and the second end surface opposite to the first end surface has a flatness not exceeding 15µm.
